# EUROPÄISCHE PATENTSCHRIFT

(11) **EP 1 878 907 B1**
(45) Veröffentlichungstag und Bekanntmachung des Hinweises auf die Patenterteilung: **06.01.2010**
(21) Anmeldenummer: 07108127.7
(22) Anmeldetag: 14.05.2007
(51) Int. Cl.: F02M 51/00, F02M 51/06, F02M 59/46, F02M 63/00, H01L 41/053

(54) **Brennstoffeinspritzventil**
Fuel injector valve
Soupape d'injection de combustible

(30) Priorität: 12.07.2006 DE 102006032218
(43) Veröffentlichungstag der Anmeldung: 16.01.2008
(73) Patentinhaber: ROBERT BOSCH GMBH, 70442 Stuttgart (DE)
(72) Erfinder: Magel, Hans-Christoph, 72793 Pfullingen (DE)

(56) Entgegenhaltungen:
- EP-A- 0 144 655
- WO-A-2004/042226
- DE-A1- 10 048 430
- DE-A1- 19 856 186
- DE-A1- 19 928 176

## Beschreibung

### Stand der Technik

Die Erfindung betrifft ein Brennstoffeinspritzventil für Brennstoffeinspritzanlagen von Brennkraftmaschinen, wie z.B. in der DE 198 56 186 offenbart. Speziell betrifft die Erfindung einen Injektor für Brennstoffeinspritzanlagen von luftverdichtenden, selbstzündenden Brennkraftmaschinen.

Aus der DE 199 28 176 A1 ist ein Piezoaktor für ein Ventil bekannt. Der bekannte Piezoaktor weist ein Piezoelement zur Beaufschlagung eines Betätigungselements mit einer Zug- oder Druckkraft auf, das mit einem Mehrschichtenaufbau von Piezolagen mit dazwischen angeordneten Elektroden und mit einer wechselseitigen seitlichen Kontaktierung der Elektroden über Außenelektroden versehen ist. Dabei sind äußere elektrische Anschlüsse für die seitliche Kontaktierung an einem inaktiven Endbereich im Lagenaufbau angebracht, so dass auf einfache Weise eine sicher herzustellende äußere Kontaktierung des Piezoaktors an inaktiven Endbereichen, die nicht mit Zug- oder Druckkräften beaufschlagt werden, möglich ist. Der inaktive Endbereich kann auch aus einem elektrisch isolierenden Keramikteil gebildet sein, an dem seitlich die Verbindung zwischen den Außenelektroden und den äußeren elektrischen Anschlüssen herstellbar ist.

Der aus der DE 199 28 176 A1 bekannte Piezoaktor hat den Nachteil, dass für den konkreten Einsatz in einem Brennstoffeinspritzventil eine aufwändige Abdichtung erforderlich ist. Speziell ist es denkbar, dass der Piezoaktor in einem Aktorraum angeordnet ist, in dem sich neben dem Aktor auch unter hohem Druck stehender Brennstoff befindet. In solch einem Fall ist eine Abdichtung denkbar, bei der die Anschlussleitungen mit Glasumschmelzungen versehen sind und diese in ein Bauteil des Brennstoffeinspritzventils, insbesondere einen Injektorkopf, eingepresst werden, um eine Abdichtung in Bezug auf den unter hohem Druck stehenden Brennstoff im Aktorraum zu gewährleisten. Solch eine Lösung ist jedoch aufwändig und mit entsprechend hohen Kosten verbunden.

### Offenbarung der Erfindung

### Vorteilhafte Wirkungen

Das erfindungsgemäße Brennstoffeinspritzventil mit den Merkmalen des Anspruchs 1 hat demgegenüber den Vorteil, dass eine zuverlässige Abdichtung der an den Aktor geführten elektrischen Anschlussleitungen gegenüber dem im Aktorraum vorgesehenen, unter hohem Druck stehenden Brennstoff mit relativ niedrigem Aufwand und somit niedrigen Kosten ermöglicht ist, wobei eine Glasumschmelzung für die elektrischen Anschlussleitungen nicht erforderlich ist.

Durch die in den Unteransprüchen aufgeführten Maßnahmen sind vorteilhafte Weiterbildungen des im Anspruch 1 angegebenen Brennstoffeinspritzventils möglich.

Die Klebstoffschicht ist vorzugsweise als dünne Klebstoffschicht ausgebildet, die aus einem Klebstoff besteht. Dadurch kann eine zuverlässige Abdichtung in Bezug auf hohe Drucke gewährleistet werden, da insbesondere die durch den Druck entstehenden, auf die Klebstoffschicht einwirkenden Scherkräfte bei dünnen Klebstoffschichten gering sind. Denn in Bezug auf den Brennstoff im Aktorraum bildet die dünne Klebstoffschicht nur eine geringe Außenfläche zum Kraftaufbau.

Erfindungsgemäß ist es, dass eine Kontaktplatte zum Kontaktieren von Elektrodenschichten des Aktors vorgesehen ist, über die sich der Aktor an der Isolierplatte abstützt, dass eine elektrische Anschlussleitung mit der Kontaktplatte kontaktiert ist und dass die Kontaktplatte durch die Klebstoffschicht mit der Isolierplatte mechanisch verbunden ist. Dabei kann die Kontaktierung der Elektrodenschichten im Rahmen des Klebeprozesses erfolgen, so dass die Herstellung des Brennstoffeinspritzventils vereinfacht werden kann. Dabei können die Kontaktplatte und die Isolierplatte im Rahmen des Klebeprozesses auch ausgerichtet werden.

Die Kontaktplatte kann als mehrteilige, insbesondere zweiteilige, Kontaktplatte ausgebildet sein, wobei eine elektrische Anschlussleitung über ein erstes Kontaktplattenteil mit den positiven Elektrodenschichten und eine andere elektrische Anschlussleitung über ein zweites Kontaktplattenteil mit den negativen Elektrodenschichten verbunden ist. Ein Freiraum zwischen den beiden Kontaktplattenteilen ist vorzugsweise mit einem elektrisch isolierenden Füllmittel aufgefüllt. Hierbei eignet sich insbesondere ein keramisches Füllmittel oder ein Klebstoff, um den Freiraum aufzufüllen. Die beiden Kontaktplattenteile können dadurch in einer Ebene senkrecht zu einer Achse des Aktors angeordnet sein, wobei sich eine gute Kraftübertragung, insbesondere eine hohe Steifigkeit, zur Abstützung des Aktors an dem Ventilgehäuse ergibt, die durch das Füllmittel unterstützt ist. Ferner ergibt sich eine Optimierung des axialen Platzbedarfs für den Aktor im Ventilgehäuse und somit eine Optimierung der Baulänge des Brennstoffeinspritzventils. Die Kontaktplatte kann in den piezoelektrischen Aktor integriert sein.
Die Kontaktplatte kann bei der Aktorherstellung im rohen Zustand auf den rohen, geschichteten Aktorverbund aufgebracht werden. Durch Sintern des Aktorverbunds mit der Kontaktplatte ergibt sich dann ein piezoelektrischer Aktor, bei dem die Kontaktplatte durch Sintern mit dem übrigen Aktorverbund verbunden ist. Gegebenenfalls können auch eine weitere Kontaktplatte sowie eine weitere Isolierplatte, die zwischen den Kontaktplatten vorgesehen ist, im jeweils noch rohen Zustand auf den Aktorverbund aufgebracht werden, um durch nachfolgendes Sintern einen piezoelektrischen Aktor auszubilden, der die beiden Kontaktplatten sowie die weitere Isolierplatte umfasst. Weitere alternative Ausgestaltungen sind ebenfalls möglich. Insbesondere kann eine gegebenenfalls zweiteilige Kontaktplatte zusammen mit einer Isolierplatte in den piezoelektrischen Aktor integriert werden. Diese Ausgestaltungen haben den Vorteil, dass eine Vorbaugruppe gebildet ist, die auf einfache Weise in das Ventilgehäuse eingesetzt werden kann, wobei die Anzahl der Klebeschichten reduziert ist und gegebenenfalls nur eine Klebeschicht zur Abdichtung der Anschlussleitungen erforderlich ist, so dass eine hohe Zuverlässigkeit im Betrieb des Brennstoffeinspritzventils gewährleistet ist.

Ferner ist es vorteilhaft, dass zum Schutz der Klebstoffschicht eine Ummantelung vorgesehen ist, die aus einer kraftstoffresistenten Beschichtung, einem Dichtring oder dergleichen, gebildet sein kann, um die Hochdruckdichtheit der vorzugsweise dünnen Klebstoffschicht weiter zu verbessern. Dadurch wird eine dauerhafte Hochdruckdichtheit sichergestellt, da ein Kontakt der Klebstoffschicht mit dem Kraftstoff verhindert ist.

### Kurze Beschreibung der Zeichnungen

Bevorzugte Ausführungsbeispiele der Erfindung sind in der nachfolgenden Beschreibung unter Bezugnahme auf die beigefügten Zeichnungen, in denen sich entsprechende Elemente mit übereinstimmenden Bezugszeichen versehen sind, näher erläutert. Es zeigt:
Fig. 1 ein erstes Ausführungsbeispiel eines Brennstoffeinspritzventils der Erfindung in einer auszugsweisen axialen Schnittdarstellung;
Fig. 2 den in Fig. 1 mit II bezeichneten Ausschnitt entsprechend einem zweiten Ausführungsbeispiel der Erfindung und
Fig. 3 den in Fig. 1 mit III bezeichneten Ausschnitt entsprechend einem dritten Ausführungsbeispiel der Erfindung.

### Ausführungsformen der Erfindung

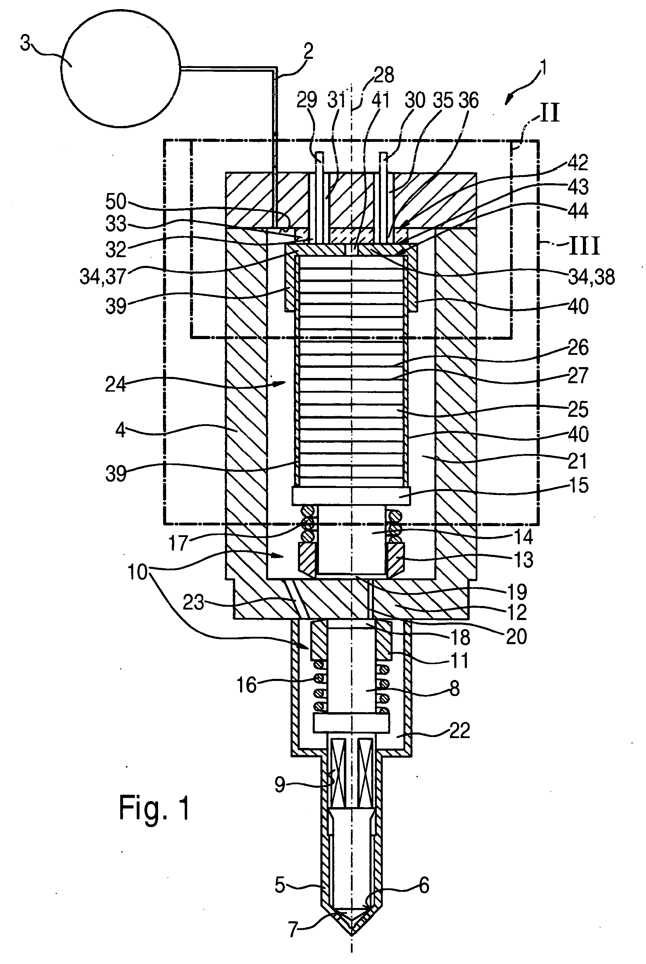

Fig. 1 zeigt ein Ausführungsbeispiel eines Brennstoffeinspritzventils 1 der Erfindung, das über eine Brennstoffleitung 2 mit einem Druckspeicher 3 verbunden ist, in einer schematischen, axialen Schnittdarstellung. Das Brennstoffeinspritzventil 1 kann insbesondere als Injektor für Brennstoffeinspritzanlagen von luftverdichtenden, selbstzündenden Brennkraftmaschinen dienen. Speziell eignet sich das Brennstoffeinspritzventil 1 für Nutzkraftwagen oder Personenkraftwagen. Ein bevorzugter Einsatz des Brennstoffeinspritzventils 1 besteht für eine Brennstoffeinspritzanlage mit einem als Common-Rail 3 ausgebildeten Druckspeicher 3, der Dieselbrennstoff unter hohem Druck zu mehreren Brennstoffeinspritzventilen 1 führt. Das erfindungsgemäße Brennstoffeinspritzventil 1 eignet sich jedoch auch für andere Anwendungsfälle.

Das Brennstoffeinspritzventil 1 weist ein mehrteiliges Ventilgehäuse 4 und einen mit dem Ventilgehäuse 4 verbundenen Ventilsitzkörper 5 auf. An dem Ventilsitzkörper 5 ist eine Ventilsitzfläche 6 ausgebildet, die mit einem Ventilschließkörper 7 zu einem Dichtsitz zusammenwirkt. Ferner ist der Ventilschließkörper 7 einstückig mit einer Ventilnadel 8 ausgebildet, die von einer Ventilnadelführung 9 in axialer Richtung geführt ist.

Das Brennstoffeinspritzventil 1 weist eine Hubübersetzungseinrichtung 10 auf. Die Hubübersetzungseinrichtung 10 umfasst eine Dichthülse 11, eine Drosselplatte 12, eine Dichthülse 13, einen zylinderförmigen Kolben 14, eine Druckplatte 15 und Ventilfedern 16, 17. Dabei schließt die Ventilnadel 8 mit der Dichthülse 11 und der Drosselplatte 12 einen im Betrieb des Brennstoffeinspritzventils 1 mit Brennstoff gefüllten Steuerraum 18 ein. Ferner schließt der Kolben 14 mit der Dichthülse 13 und der Drosselplatte 12 einen Raum 19 ein, der über eine in der Drosselplatte 12 ausgebildete Drossel 20 mit dem Steuerraum 18 in Verbindung steht. Durch das Verhältnis eines Querschnitts des Raums 19 zu einem Querschnitt des Steuerraums 18 lässt sich ein Hubübersetzungsverhältnis einstellen, um einen Hub des Kolbens 14 in einen entsprechenden Hub der Ventilnadel 8 umzusetzen. Die Druckplatte 15, der Kolben 14, die Ventilfeder 17 und die Dichthülse 13 sind in einem Aktorraum 21 angeordnet, während die Dichthülse 11, die Ventilfeder 16 und die Ventilnadel 8 in einem Brennstoffraum 22 angeordnet sind. Im Betrieb des Brennstoffeinspritzventils 11 wird Brennstoff aus dem Druckspeicher 3 über die Brennstoffleitung 2 in den Aktorraum 21 gefördert. Aus dem Aktorraum 21 gelangt der Brennstoff über einen in der Drosselplatte 12 ausgebildeten Brennstoffkanal 23 in den Brennstoffraum 22.

In dem Aktorraum 21 ist außerdem ein Aktor 24 angeordnet, der eine Vielzahl von keramischen Schichten 25 und eine Vielzahl von zwischen den keramischen Schichten 25 angeordneten Elektrodenschichten 26, 27 aufweist. Dabei sind die Elektrodenschichten 26, 27 abwechselnd als positive Elektrodenschichten 26 und als negative Elektrodenschichten 27 ausgestaltet, wobei in der Fig. 1 nur die Schichten 25, 26, 27 gekennzeichnet sind. Bei einer Betätigung des Brennstoffeinspritzventils 1 wird der im Ausgangszustand geladene Aktor 24 entladen, wodurch sich dieser in Richtung einer Achse 28 des Aktors 24 zusammenzieht, so dass die über die Hubübersetzungseinrichtung 10 vermittelte Verstellbewegung zu einem Öffnen der Ventilnadel 8 führt, bei dem der zwischen dem Ventilschließkörper 7 und der Ventilsitzfläche 6 gebildete Dichtsitz geöffnet wird, um ein Abspritzen von Brennstoff aus dem Brennstoffraum 22 über eine oder mehrere Düsenöffnungen in dem Ventilsitzkörper 5 zu ermöglichen. Anschließend wird der Aktor 24 wieder geladen, so dass es zum Schließen der Ventilnadel 8 kommt, wodurch der zwischen dem Ventilschließkörper 7 und der Ventilsitzfläche 6 gebildete Dichtsitz wieder geschlossen ist.

Zum Laden und Entladen des Aktors 24 sind elektrische Anschlussleitungen 29, 30 vorgesehen, wobei die Anschlussleitung 29 durch eine Bohrung 31 in dem Ventilgehäuse 4 und durch eine durchgehende Aussparung 32 in einer in dem Aktorraum 21 angeordnete Isolierplatte 33 an eine ebenfalls in dem Aktorraum 21 angeordnete Kontaktplatte 34 geführt ist und wobei die Anschlussleitung 30 durch eine Bohrung 35 in dem Ventilgehäuse 4 und durch eine durchgehende Aussparung 36 in der Isolierplatte 33 zu der Kontaktplatte 34 geführt ist. Die Kontaktplatte 34 ist zweiteilig ausgestaltet und weist einen ersten Kontaktplattenteil 37 und einen zweiten Kontaktplattenteil 38 auf. Die Anschlussleitung 29 ist elektrisch mit dem ersten Kontaktplattenteil 37 der Kontaktplatte 34 verbunden, und die Anschlussleitung 30 ist mit dem zweiten Kontaktplattenteil 38 der Kontaktplatte 34 verbunden. Über eine mit der Kontaktplatte 34 verbundene Außenelektrode 39 ist die Anschlussleitung 29 beispielsweise mit den positiven Elektrodenschichten 26 verbunden, während die Anschlussleitung 30 über eine mit der Kontaktplatte 34 verbundene Außenelektrode 40 mit den negativen Elektrodenschichten 27 verbunden ist. In einem bei der Herstellung des Aktors 24 verbleibenden Freiraum zwischen den Kontaktplattenteilen 37, 38 der Kontaktplatte 34 ist ein elektrisch isolierendes Füllmittel 41 eingebracht, das beispielsweise aus einer Keramik oder einem Klebstoff bestehen kann, um die Kontaktplattenteile 37, 38 voneinander elektrisch zu isolieren.

Die Isolierplatte 33 kann beispielsweise aus einem keramischen Material bestehen. Über die mit dem Füllmittel 41 geschlossene Kontaktplatte 34 und die Isolierplatte 33 ist eine vorteilhafte Abstützung des Aktors 24 an dem Ventilgehäuse 4 gewährleistet, die eine hohe Steifigkeit hat. Zur Abdichtung der durchgehenden Aussparungen 32, 36 in der Isolierplatte 33 sowie der Bohrungen 31, 35 in dem Ventilgehäuse 4 gegenüber dem Aktorraum 21, in dem sich im Betrieb des Brennstoffeinspritzventils 1 unter hohem Druck stehender Brennstoff befindet, sind Klebstoffschichten 42, 43, 44 vorgesehen, die jeweils aus zumindest einem Klebstoff bestehen. Dabei ist die Klebstoffschicht 42 zwischen einer Innenwand 50 des Ventilgehäuses 4 und der Isolierplatte 33 vorgesehen, die Klebstoffschicht 43 ist zwischen der Isolierplatte 33 und der Kontaktplatte 34 vorgesehen und ferner ist die Klebstoffschicht 44 zwischen der Kontaktplatte 34 und einer der keramischen Schichten 25 des Aktors 24 vorgesehen. Speziell die Klebstoffschichten 42, 43 sind als dünne Klebstoffschichten 42, 43 ausgestaltet, um eine geringe Angriffsfläche für den unter hohem Druck stehenden Brennstoff im Aktorraum 21 zu bieten, so dass die in den Klebstoffschichten 42, 43 auftretenden Scherkräfte gering sind und eine hohe Druckbeständigkeit gewährleistet ist.

Um die Elektrodenschichten 26, 27 gegenüber dem im Aktorraum 21 vorgesehenen Brennstoff zu schützen, sind diese vorzugsweise nur im Bereich einer Außenkontaktierung mittels der Außenelektroden 39, 40 an die Außenseite des Aktors 24 geführt und im Übrigen in den keramischen Schichten 25 vergraben. Dadurch wird auch eine Beschädigung durch elektrische Kurzschlüsse vermieden.

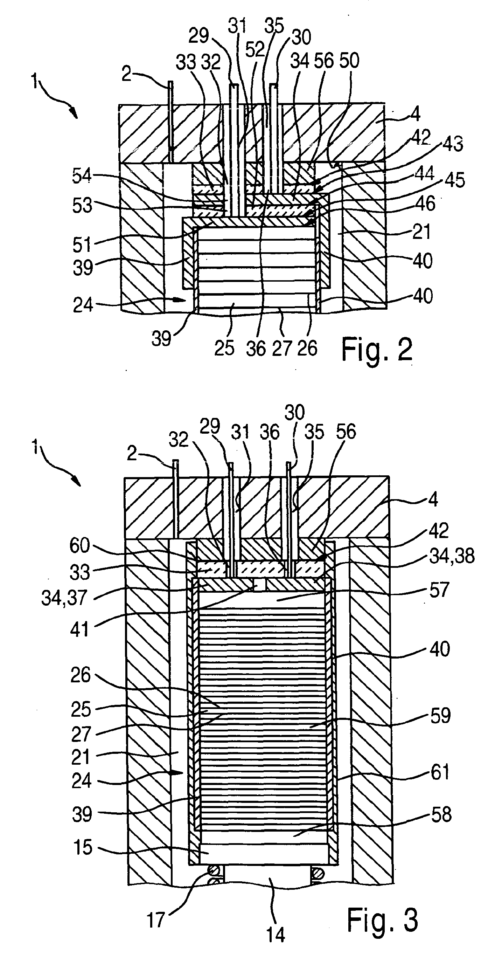

Fig. 2 zeigt den in Fig. 1 mit II bezeichneten Ausschnitt eines Brennstoffeinspritzventils 1 gemäß einem zweiten Ausführungsbeispiel der Erfindung. In diesem Ausführungsbeispiel ist eine weitere Kontaktplatte 51 vorgesehen, wobei die Kontaktplatten 34, 51 zumindest in etwa den gleichen Querschnitt wie der Aktor 24 aufweisen. Zwischen der Kontaktplatte 34 und der weiteren Kontaktplatte 51 ist eine weitere Isolierplatte 52 vorgesehen, die beispielsweise aus einem keramischen Material besteht. Die weitere Isolierplatte 52 weist eine durchgehende Aussparung 53 auf und die Kontaktplatte 34 weist ebenfalls eine durchgehende Aussparung 54 auf. Ferner ist eine Stützplatte 56 vorgesehen, die den durchgehenden Aussparungen 32, 36 in der Isolierplatte 33 entsprechende durchgehende Aussparungen aufweist. Die Anschlussleitung 29 erstreckt sich durch die Stützplatte 56, durch die durchgehende Aussparung 32 in der Isolierplatte 33, die durchgehende Aussparung 54 in der Kontaktplatte 34 und die durchgehende Aussparung 53 in der Isolierplatte 52 und kontaktiert die weitere Kontaktplatte 51. Die Anschlussleitung 30 erstreckt sich durch die Bohrung 35 in dem Ventilgehäuse 4, die Stützplatte 56 und durch die durchgehende Aussparung 36 in der Isolierplatte 33 und kontaktiert die Kontaktplatte 34.

Die weitere Kontaktplatte 51 ist durch eine Klebstoffschicht 45 mit einer der keramischen Schichten 25 des Aktors 24 verbunden. Ferner ist die weitere Kontaktplatte 51 mittels einer Klebstoffschicht 45 mit der Isolierplatte 52 verbunden. Entsprechend ist die Isolierplatte 52 mit der Kontaktplatte 34 durch eine Klebstoffschicht 44 verbunden, während die Kontaktplatte 34 mit der Isolierplatte 33 mittels einer Klebstoffschicht 53 verbunden ist. Hierbei kann in Bezug auf den Aktorverbund, der die Isolierplatten 33, 52 sowie die Kontaktplatten 34, 51 umfasst, eine Vormontage erfolgen. Bei der Endmontage des Brennstoffeinspritzventils 1 kann dieser Aktorverbund mittels einer Klebstoffschicht 52 mit der Stützplatte 56 verbunden werden. Die Anschlussleitungen 29, 30 sind durch die Klebstoffschichten 42 bis 46 gegenüber dem Aktorraum 42 abgedichtet, wobei durch eine vorzugsweise dünne Ausgestaltung der Klebstoffschichten 42 bis 45 eine hohe Druckbeständigkeit gewährleistet ist.

Fig. 3 zeigt den Fig. 1 mit III bezeichneten Ausschnitt des Brennstoffeinspritzventils 1 entsprechend einem dritten Ausführungsbeispiel der Erfindung. Dabei ist die Kontaktplatte 34 entsprechend dem in Fig. 1 dargestellten ersten Ausführungsbeispiel als zweiteilige Kontaktplatte mit dem ersten Kontaktplattenteil 37 und dem zweiten Kontaktplattenteil 38 ausgestaltet, wobei ein Füllmittel 41 zwischen den beiden Kontaktplattenteilen 37, 38 vorgesehen ist. Außerdem sind abweichend von dem in Fig. 1 dargestellten ersten Ausführungsbeispiel die durchgehenden Aussparungen 32, 36 in der Isolierplatte 33 mit einem leitenden Material ausgefüllt, das dem Material der Kontaktplatte 34 entsprechen kann. Ferner weist der Aktor 24 einen inaktiven Aktorfußbereich 57, einen inaktiven Aktorkopfbereich 58, in denen gegebenenfalls vorgesehene Elektrodenschichten nicht kontaktiert sind oder keine Elektrodenschichten vorgesehen sind, und einen aktiven Aktorbereich 59 auf. Die Isolierplatte 33 mit dem in den durchgehenden Aussparungen 32, 36 vorgesehenen elektrisch leitenden Material, die Kontaktplatte 34 mit dem Füllmittel 41 und der restliche Aktor, der den Aktorfußbereich 57, den Aktorkopfbereich 58 und den Aktorbereich 59 umfasst, sind vorzugsweise zusammen gesintert und dadurch miteinander verbunden, so dass ein Aktormodul ausgebildet ist. Zur Montage dieses Aktormoduls wird die Isolierplatte 33 mit der Stützplatte 56 durch die Klebstoffschicht 42 verbunden, wodurch die durchgehenden Aussparungen 32, 36 in der Isolierplatte 33 und die Bohrungen 31, 35 in dem Gehäuse 4 gegenüber dem Aktorraum 21 abgedichtet sind. Ferner ist zum Schutz der Klebstoffschicht 42 in zumindest einem Bereich 60 der Klebstoffschicht 42 eine Ummantelung vorgesehen, die in diesem Ausführungsbeispiel auch die Stützplatte 56, die Isolierplatte 33, die Kontaktplatte 34 sowie den übrigen Aktor 21 einschließlich der an den Aktor 21 angefügten Druckplatte 15 ummantelt. Dadurch wird zum einen ein Schutz gegen chemische Einwirkungen des in dem Aktorraum 21 vorgesehenen Brennstoffs auf die Klebstoffschicht 42 erreicht. Zum anderen ermöglicht die in diesem Ausführungsbeispiel beschriebene Ummantelung 61 auch eine elektrische Isolierung gegenüber dem aktiven Aktorbereich 59, um Kurzschlüsse zwischen den Elektrodenschichten 26, 27 zu verhindern.

Die Erfindung ist nicht auf die beschriebenen Ausführungsbeispiele beschränkt.

## Patentansprüche

1. Brennstoffeinspritzventil (1), insbesondere Injektor für Brennstoffeinspritzanlagen von luftverdichtenden, selbstzündenden Brennkraftmaschinen, mit einem Ventilgehäuse (4), einem in einem Aktorraum (21) des Ventilgehäuses (4) angeordneten piezoelektrischen Aktor (24), der mit in das Ventilgehäuse (4) geführten elektrischen Anschlussleitungen (29, 30) verbunden ist, und einem von dem Aktor (24) zumindest mittelbar betätigbaren Ventilschließkörper (7), wobei zumindest eine Isolierplatte (33) vorgesehen ist, wobei die elektrischen Anschlussleitungen (29, 30) durch zumindest eine in der Isolierplatte (33) ausgebildete durchgehende Aussparung (32, 36) zu dem Aktor (24) geführt sind und wobei zumindest eine Klebstoffschicht (42, 43) zum Abdichten der in der isolierplatte (33) ausgebildeten durchgehenden Aussparung (32, 36) gegenüber dem Aktorraum (21) vorgesehen ist,
**dadurch gekennzeichnet,**
**dass** die Isolierplatte (33) elektrisch isolierend ausgeführt ist und zumindest eine Kontaktplatte (34) zum Kontaktieren von Elektrodenschichten (26, 27) des Aktors (24) vorgesehen ist, uber die sich der Aktor (24) an der isolierplatte (33) abstutzt,
**dass** zumindest eine der elektrischen Anschlussleitungen (29, 30) mit der Kontaktplatte (34) elektrisch verbunden ist und dass die Kontaktplatte (34) mittels der Klebstoffschicht (43) mit der Isolierplatte (33) verbunden ist.

2. Brennstoffeinspritzventil nach Anspruch 1,
**dadurch gekennzeichnet,**
**dass** die Klebstoffschicht (42, 43) zumindest im Wesentlichen aus einem Klebstoff besteht und als dünne Klebstoffschicht (42, 43) ausgebildet ist.

3. Brennstoffeinspritzventil nach Anspruch 1,
**dadurch gekennzeichnet,**
**dass** die Kontaktplatte (34) als zumindest zweiteilige Kontaktplatte (34) ausgebildet ist, dass eine der elektrischen Anschlussleitungen (29) mittels eines ersten Kontaktplattenteils (37) mit den positiven Elektrodenschichten (26) des Aktors (24) und die andere elektrische Anschlussleitung (30) mittels eines zweiten Kontaktplattenteils (38) mit den negativen Elektrodenschichten (27) des Aktors (24) verbunden ist.

4. Brennstoffeinspritzventil nach Anspruch 3,
**dadurch gekennzeichnet,**
**dass** zwischen dem ersten Kontaktplattenteil (37) und dem zweiten Kontaktplattenteil (38) ein elektrisch isolierendes Füllmittel (41), insbesondere ein keramisches Füllmittel (41) oder ein Klebstoff (41), vorgesehen ist.

5. Brennstoffeinspritzventil nach einem der Ansprüche 1 bis 4,
**dadurch gekennzeichnet,**
**dass** der piezoelektrische Aktor (24) die Kontaktplatte (34) umfasst.

6. Brennstoffeinspritzventil nach einem der Ansprüche 1 bis 2,
**dadurch gekennzeichnet,**
**dass** eine weitere Kontaktplatte (51) vorgesehen ist, dass eine elektrische Anschlussleitung (30) mit der Kontaktplatte (34) und eine weitere elektrische Anschlussleitung (29) mit der weiteren Kontaktplatte (51) elektrisch verbunden ist, dass zwischen der Kontaktplatte (34) und der weiteren Kontaktplatte (51) eine weitere elektrisch isolierende Isolierplatte (52) vorgesehen ist, dass die weitere Isolierplatte (52) zumindest eine durchgehende Aussparung (53) aufweist, durch die die weitere Anschlussleitung (29) an die weitere Kontaktplatte (51) geführt ist und dass zumindest eine weitere Klebstoffschicht (44, 45) zum Abdichten zumindest der in der weiteren Isolierplatte (52) ausgebildeten Aussparung (53) gegenüber dem Aktorraum (21) vorgesehen ist.

7. Brennstoffeinspritzventil nach Anspruch 6,
**dadurch gekennzeichnet,**
**dass** die weitere Isolierplatte (52) mittels der weiteren Klebstoffschicht (44) mit der Kontaktplatte (34) und mittels einer dritten Klebstoffschicht (45) mit der weiteren Kontaktplatte (51) verbunden ist.

8. Brennstoffeinspritzventil nach einem der Ansprüche 1 bis 7,
**dadurch gekennzeichnet,**
**dass** zum Schutz der Klebstoffschicht (42, 43, 44, 45) zumindest in einem Bereich (60) der Klebstoffschicht (42, 43, 44, 45) eine Ummantelung (61) vorgesehen ist, die zumindest teilweise auch die Isolierplatte (33) und die Kontaktplatte (34) ummantelt.

9. Brennstoffeinspritzventil nach einem der Ansprüche 1 bis 4,
**dadurch gekennzeichnet,**
**dass** der piezoelektrische Aktor (24) die Kontaktplatte (34) und die Isolierplatte (33) umfasst, dass der Aktor (24) mit einer Stützplatte (56) an dem Ventilgehäuse (4) abgestützt ist und dass die Isolierplatte (33) mittels der Klebstoffschicht (42) mit der Stützplatte (56) verbunden ist.

## Claims

1. Fuel injection valve (1), in particular injector for fuel injection systems of air-compressing autoignition internal combustion engines, having a valve housing (4), having a piezoelectric actuator (24) which is arranged in an actuator chamber (21) of the valve housing (4) and which is connected to electrical connecting lines (29, 30) which are guided into the valve housing (4), and having a valve closing body (7) which can be actuated at least indirectly by the actuator (24), with at least one insulating plate (33) being provided, with the electrical connecting lines (29, 30) being guided to the actuator (24) through at least one continuous cutout (32, 36) which is provided in the insulating plate (33), and with at least one adhesive layer (42, 43) for sealing off the continuous cutout (32, 36) which is provided in the insulating plate (33) being provided opposite the actuator chamber (21),
**characterized**
**in that** the insulating plate (33) is of electrically insulating design and at least one contact plate (34) is provided for contacting electrode layers (26, 27) of the actuator (24), via which contact plate (34) the actuator (24) is supported on the insulating plate (33), in that at least one of the electrical connecting lines (29, 30) is electrically connected to the contact plate (34) and in that the contact plate (34) is connected to the insulating plate (33) by means of the adhesive layer (43).

2. Fuel injection valve according to Claim 1,
**characterized**
**in that** the adhesive layer (42, 43) is composed at least substantially of an adhesive and is formed as a thin adhesive layer (42, 43).

3. Fuel injection valve according to Claim 1,
**characterized**
**in that** the contact plate (34) is designed as an at least two-part contact plate (34), in that one of the electrical connecting lines (29) is connected by means of a first contact plate part (37) to the positive electrode layers (26) of the actuator (24) and the other electrical connecting line (30) is connected by means of a second contact plate part (38) to the negative electrode layers (27) of the actuator (24).

4. Fuel injection valve according to Claim 3,
**characterized**
**in that** an electrically insulating filling material (41), in particular a ceramic filling material (41) or an adhesive (41), is provided between the first contact plate part (37) and the second contact plate part (38).

5. Fuel injection valve according to one of Claims 1 to 4,
**characterized**
**in that** the piezoelectric actuator (24) comprises the contact plate (34).

6. Fuel injection valve according to one of Claims 1 to 2,
**characterized**
**in that** a further contact plate (51) is provided, in that one electrical connecting line (30) is electrically connected to the contact plate (34) and a further electrical connecting line (29) is electrically connected to the further contact plate (51), in that a further electrically insulating insulating plate (52) is provided between the contact plate (34) and the further contact plate (51), in that the further insulating plate (52) has at least one continuous cutout (53) through which the further connecting line (29) is guided to the further contact plate (51), and in that at least one further adhesive layer (44, 45) is provided for sealing off at least the cutout (53), which is formed in the further insulating plate (52), with respect to the actuator chamber (21).

7. Fuel injection valve according to Claim 6,
**characterized**
**in that** the further insulating plate (52) is connected by means of the further adhesive layer (44) to the contact plate (34) and by means of a third adhesive layer (45) to the further contact plate (51).

8. Fuel injection valve according to one of Claims 1 to 7,
**characterized**
**in that,** to protect the adhesive layer (42, 43, 44, 45), a casing (61) is provided at least in a region (60) of the adhesive layer (42, 43, 44, 45), which casing (61) at least partially also encapsulates the insulating plate (33) and the contact plate (34).

9. Fuel injection valve according to one of Claims 1 to 4,
**characterized**
**in that** the piezoelectric actuator (24) comprises the contact plate (34) and the insulating plate (33), in that the actuator (24) is supported with a support plate (56) on the valve housing (4), and in that the insulating plate (33) is connected by means of the adhesive layer (42) to the support plate (56).

## Revendications

1. Soupape d'injection de carburant (1), en particulier injecteur pour des installations d'injection de carburant de moteurs à combustion interne à auto-allumage et à compression d'air, comprenant un boîtier de soupape (4), un actionneur piézoélectrique (24) disposé dans un espace d'actionneur (21) du boîtier de soupape (4), qui est connecté à des conduites de raccordement électriques (29, 30) guidées dans le boîtier de soupape (4), et un corps de fermeture de soupape (7) pouvant être actionné au moins de manière indirecte par l'actionneur (24), au moins une plaque isolante (33) étant prévue, les conduites de raccordement électriques (29, 30) étant guidées à travers au moins un évidement continu (32, 36) réalisé dans la plaque isolante (33) jusqu'à l'actionneur (24) et au moins une couche d'adhésif (42, 43) étant prévue pour étancher l'évidement continu (32, 36) réalisé dans la plaque isolante (33) vis-à-vis de l'espace d'actionneur (21),
**caractérisée en ce que**
la plaque isolante (33) est réalisée de manière électriquement isolante et au moins une plaque de contact (34) est prévue pour venir en contact avec des couches d'électrodes (26, 27) de l'actionneur (24), par le biais de laquelle l'actionneur (24) s'appuie contre la plaque isolante (33), **en ce qu'**au moins l'une des conduites de raccordement électriques (29, 30) est connectée électriquement à la plaque de contact (34) et **en ce que** la plaque de contact (34) est connectée au moyen de la couche d'adhésif (43) à la plaque isolante (33).

2. Soupape d'injection de carburant selon la revendication 1,
**caractérisée en ce que**
la couche d'adhésif (42, 43) se compose au moins essentiellement d'un adhésif et est réalisée sous forme de couche d'adhésif mince (42, 43).

3. Soupape d'injection de carburant selon la revendication 1,
**caractérisée en ce que**
la plaque de contact (34) est réalisée sous forme de plaque de contact (34) en au moins deux parties, **en ce que** l'une des conduites de raccordement électriques (29) est connectée au moyen d'une première partie de plaque de contact (37) aux couches d'électrodes positives (26) de l'actionneur (24) et l'autre conduite de raccordement électrique (30) est connectée au moyen d'une deuxième partie de plaque de contact (38) aux couches d'électrodes négatives (27) de l'actionneur (24).

4. Soupape d'injection de carburant selon la revendication 3,
**caractérisée en ce que**
l'on prévoit entre la première partie de plaque de contact (37) et la deuxième partie de plaque de contact (38) une charge électriquement isolante (41), en particulier une charge en céramique (41) ou un adhésif (41).

5. Soupape d'injection de carburant selon l'une quelconque des revendications 1 à 4,
**caractérisée en ce que**
l'actionneur piézoélectrique (24) comprend la plaque de contact (34).

6. Soupape d'injection de carburant selon l'une quelconque des revendications 1 à 2,
**caractérisée en ce que**
l'on prévoit une autre plaque de contact (51), **en ce qu'**une conduite de raccordement électrique (30) est connectée électriquement à la plaque de contact (34) et une autre conduite de raccordement électrique (29) est connectée électriquement à l'autre plaque de contact (51), **en ce qu'**entre la plaque de contact (31) et l'autre plaque de contact (51) est prévue une autre plaque isolante (52) électriquement isolante, **en ce que** l'autre plaque isolante (52) présente au moins un évidement continu (53), à travers lequel est guidée l'autre conduite de raccordement (29) sur l'autre plaque de contact (51), et **en ce qu'**au moins une autre couche d'adhésif (44, 45) est prévue pour étancher au moins l'évidement (53) réalisé dans l'autre plaque isolante (52) vis-à-vis de l'espace d'actionneur (21).

7. Soupape d'injection de carburant selon la revendication 6,
**caractérisée en ce que**
l'autre plaque isolante (52) est connectée au moyen de l'autre couche d'adhésif (44) à la plaque de contact (34) et au moyen d'une troisième couche d'adhésif (45) à l'autre plaque de contact (51).

8. Soupape d'injection de carburant selon l'une quelconque des revendications 1 à 7,
**caractérisée en ce que**
pour la protection de la couche d'adhésif (42, 43, 44, 45), on prévoit un enrobage (61) au moins dans une région (60) de la couche d'adhésif (42, 43, 44, 45), lequel enrobe au moins en partie aussi la plaque isolante (33) et la plaque de contact (34).

9. Soupape d'injection de carburant selon l'une quelconque des revendications 1 à 4,
**caractérisée en ce que**
l'actionneur piézoélectrique (24) comprend la plaque de contact (34) et la plaque isolante (33), **en ce que** l'actionneur (24) est supporté avec une plaque de support (56) contre le boîtier de soupape (4) et **en ce que** la plaque isolante (33) est connectée au moyen de la couche d'adhésif (42) à la plaque de support (56).
